Europäisches Patentamt

European Patent Office

Office européen des brevets

(19)

(11) Veröffentlichungsnummer: **0 315 877 B1**

## (12) EUROPÄISCHE PATENTSCHRIFT

(45) Veröffentlichungstag der Patentschrift:
21.08.91 Patentblatt 91/34

(51) Int. Cl.⁵: **H03K 5/02, H03K 3/03**

(21) Anmeldenummer: **88118184.6**

(22) Anmeldetag: **02.11.88**

---

(54) **Verstärker.**

---

(30) Priorität: **07.11.87 DE 3737862**

(43) Veröffentlichungstag der Anmeldung:
**17.05.89 Patentblatt 89/20**

(45) Bekanntmachung des Hinweises auf die
Patenterteilung:
**21.08.91 Patentblatt 91/34**

(84) Benannte Vertragsstaaten:
**CH DE GB LI**

(56) Entgegenhaltungen:
**EP-A- 0 165 748
CA-A- 1 173 920
US-A- 4 233 575**

(56) Entgegenhaltungen:
**EDN, Band 22, Nr. 16, 5. September 1977,
Seiten 89-93; B. O'NEIL: "IC timers - the "old
reliable" 555 has company"
PATENT ABSTRACTS OF JAPAN, Band 9, Nr.
255 (E-349)[1978], 12. Oktober 1985; & JP-A-60
103 724**

(73) Patentinhaber: **EUROSIL electronic GmbH
Erfurter Strasse 16
W-8057 Eching (DE)**

(72) Erfinder: **Lingstaedt, Ernst
Herzog-Arnulf-Strasse 10
W-8011 Zorneding (DE)**

(74) Vertreter: **Maute, Hans-Jürgen, Dipl.-Ing.
TELEFUNKEN electronic GmbH
Theresienstrasse 2
W-7100 Heilbronn (DE)**

---

## Beschreibung

Die Erfindung betrifft eine Verstärkerschaltung gemäß dem Oberbegriff des Patentanspruches 1 sowie die Verwendung einer solchen Verstärkerschaltung für eine Oszillatorschaltung.

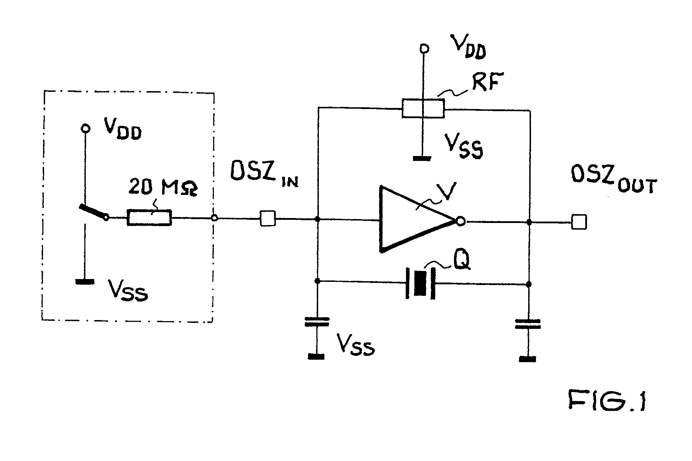

Für Uhrenschaltungen werden bekanntlich Oszillatorschaltungen benötigt, deren Aufbau die Figur 1 zeigt. Nach der Figur 1 bestehen bekannte Oszillatorschaltungen für Uhrenschaltungen aus einem Verstärker V, einem parallel zum Verstärker geschalteten Quarzkristall Q und aus einem parallel zum Verstärker geschalteten ohmschen Widerstand $R_F$, der im Beispiel der Figur 1 aus zwei parallel geschalteten Transistoren vom entgegengesetzten Leitungstyp besteht. Um die Funktionssicherheit einer Uhrenschaltung auch beim Auftreten von Leckströmen zu garantieren, werden Uhrenschaltungen einem Test unterzogen, bei dem der Oszillator gemäß der Figur 1 mit einem ohmschen Widerstand beschaltet wird, der beispielsweise einen Widerstandswert von 20 M$\Omega$ aufweist. Der Oszillator der Figur 1 ist auf seiner Eingangsseite gleichspannungsmäßig angekoppelt. Bei einer gleichspannungsmäßigen Kopplung des Oszillatoreinganges wird jedoch der Oszillator aus seinem Arbeitspunkt gebracht, wenn der Oszillatoreingang mit einem 20 M$\Omega$-Widerstand nach $V_{DD}$ oder $V_{SS}$ beschaltet wird. Die Arbeitspunktverschiebung hat zur Folge, daß die Verstärkung des Oszillators abnimmt, wodurch die Oszillatorschwingungen nicht mehr aufrecht erhalten werden können. Eine Arbeitspunktverschiebung bei Beschaltung mit einem ohmschen Widerstand am Eingang des Oszillators kann bei der Schaltung der Figur 1 nur dadurch minimiert werden, daß der Feedback-Widerstand $R_F$ möglichst niederohmig gehalten wird und beispielsweise nur einen Widerstandswert von 1 M$\Omega$ aufweist. Durch einen so kleinen Feedback-Widerstand wird jedoch die Stromaufnahme der Oszillatorschaltung drastisch erhöht.

Die Schaltung der Figur 1 hat weiterhin den Nachteil, daß sie keine kapazitive Trennung des Oszillatoreingangs ermöglicht, weil der Feedback-Widerstand $R_F$ nicht nennenswert größer als 10 M$\Omega$ gemacht werden kann, wenn er, wie allgemein üblich, durch zwei zueinander parallel geschaltete CMOS-Transistoren vom entgegengesetzten Leitungstyp realisiert wird. Ein so geringer $R_F$-Widerstand hätte nämlich in Verbindung mit einer kapazitiven Ankopplung des Oszillatoreingangs eine zu geringe Grenzfrequenz der Oszillatorschaltung und damit eine erhebliche Dämpfung sowie Phasendrehung zur Folge.

Aus der JP-A-60-103724 ist eine Verstärkerschaltung der eingangs genannten Art bekannt, die als Schaltkreis zur Pulsweitenmodulation dient. Am invertierenden Eingang des Verstärkers sind zwei Stromquellen sowie ein Kondensator angeschaltet, während ein Rückkopplungszweig auf den nichtinvertierenden Eingang geführt ist. Zusätzlich steuert der Ausgang des Verstärkers über einen Schalter eine der beiden angeschlossenen Stromquellen. Um einen von den Spannungsschwankungen der Betriebsspannungsquelle unabhängigen Modulationsbetrieb zu gewährleisten, werden die beiden Stromquellen derart gesteuert, daß sie ein konstantes Stromverhältnis für den Lade- und Entladevorgang aufweisen. Der Nachteil dieser bekannten Schaltung besteht darin, daß die Betriebsspannungsquelle aus zwei einzelnen Spannungsquellen aufgebaut ist, die jeweils eine der beiden Stromquellen speisen. Schließlich wird dieser bekannte Schaltkreis auch eine hohe Stromaufnahme aufweisen, da in dessen Rückkopplungszweig sowie in dem Schaltungszweig zur Steuerung des Schalters Widerstände vorgesehen sind.

Der Erfindung liegt die Aufgabe zugrunde, eine Verstärkerschaltung mit niedriger Stromaufnahme und damit hoher Eingangsimpedanz anzugeben, die eine kapazitive Kopplung des Eingangssignals ermöglicht. Diese Aufgabe wird bei einer Verstärkerschaltung nach der Erfindung durch die kennzeichnenden Merkmale des Anspruchs 1 gelöst.

Das Wesen der Erfindung besteht demnach darin, mittels der Konstantstromquelle sowie der Stromspiegelschaltungen die Wirkung einer hochohmigen Rückkopplung zu erzielen, wodurch eine Reduzierung der Stromaufnahme ermöglicht wird. Ferner läßt diese hochohmige Rückkopplung eine kapazitive Kopplung eines Eingangssignals zu, wodurch die oben genannten Nachteile bei Verwendung der erfindungsgemäßen Verstärkerschaltung in einer Oszillatorschaltung nicht auftreten.

Vorteilhafte Weiterbildungen der erfindungsgemäßen Verstärkerschaltung sind den Ansprüchen 2 bis 4 zu entnehmen.

Die Erfindung wurde im folgenden an Ausführungsbeispielen im Zusammenhang mit den Figuren erläutert. Es zeigen :

Figur 2    ein Schaltbild eines Ausführungsbeispieles der erfindungsgemäßen Verstärkerschaltung,

Figur 3    ein Schaltbild eines weiteren Ausführungsbeispieles der erfindungsgemäßen Verstärkerschaltung und

Figur 4    ein Blockschaltbild der Schaltungsanordnung gemäß der Figur 3.

In den Figuren sind Bauelemente gleicher Funktion mit den gleichen Bezugszeichen versehen.

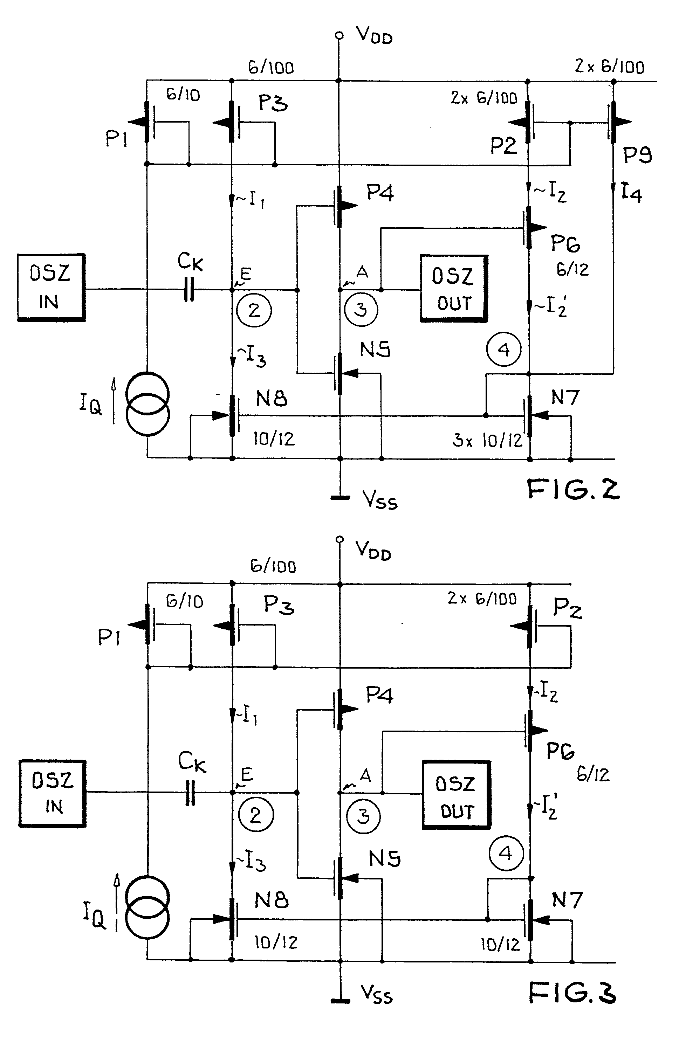

Die Figur 2 zeigt ein Ausführungsbeispiel einer Verstärkerschaltung nach der Erfindung im Detail, die beispielsweise als Oszillatorschaltung einer Uhrenschaltung verwendet werden kann. Der aus den Transistoren P4 und N5 bestehende Inverter bildet das aktive Element (Verstärker) der Oszillatorschaltung der Figur 2. Die mit "P" bezeichneten Transistoren sind im Ausführungsbeispiel der Figur 2 P-Kanal-Transistoren und die mit "N" bezeichneten Transistoren sind im Ausführungsbeispiel der Figur 2 N-Kanal-Transistoren. Über die Stromspiegelschaltung P1 (Transistor P1) werden bei der Schaltung der Figur 2 aus dem Quellenstrom $I_Q$ die drei Sromspiegel $I_1$, $I_2$ und $I_4$ gespeist. Der Stromspiegel $I_1$ besteht aus dem Transistor P3, der Stromspiegel $I_2$ aus dem Transistor P2 und der Stromspiegel $I_4$ aus dem Transistor P9. Die w/l-Verhältnisse der Transistoren P1, P3, P2, P9 sind dabei so gewählt, daß mit einem Quellenstrom $I_Q$ von z. B. 10 nA die Drainströme $I_1$, $I_2$, $I_4$ der Transistoren P3, P2, P9 im nA-Bereich liegen und das Verhältnis der Ströme $I_1 : I_2 : I_4 = 1 : 2 : 2$ beträgt. Durch den Stromspiegel N7, N8 wird die Summe der Ströme $I_2' + I_3$ mit einem Übersetzungsverhältnis von 3 : 1 auf den Knoten 2 der Oszillatorschaltung zurückgeführt. Durch den Transistor P6 wird der Strom des Stromspiegels $I_2$ mit dem Oszillatorausgangssignal moduliert. Der Ausgangsstrom des Transistors P6 ist $I_2'$. $I_2'$ ist gleich $I_2$, wenn P6 durchgeschaltet ist. Ist P6 dagegen gesperrt, so ist $I_2' = 0$. Je nach Größe der Spannung am Verstärkerausgang (Knoten 3) ; kann der Strom $I_2'$ zwischen 0 und Maximalwert $= I_2$ variieren.

Die Schaltung der Figur 2 funktioniert wie folgt. Wenn der Eingang $OSZ_{IN}$ nach $V_{DD}$ bzw. $V_{SS}$ gelegt wird, so tritt zum Einschaltzeitpunkt diese Spannung ebenfalls am Knoten 2 auf, da $C_k$ zu diesem Zeitpunkt entladen ist. Wenn sich der Schaltungsknoten 2 auf $V_{SS}$ befindet, so liegt der Oszillatorausgang (Knoten 3) auf $V_{DD}$. Dadurch ist der Transistor P6 gesperrt, d. h. $I_2' = 0$. Über den Stromspiegel N7, N8 wird in diesem Fall nur $I_4$ mit dem entsprechenden Verhältnis zum Knoten 2 zurückgeführt.

Da $I_4 = 2 \cdot I_1$ und $I_3 = 1/3\ I_{N7}$ ist, liefert der Transistor N8 für den Fall, daß P6 gesperrt ist, einen Strom $I_3 = 2/3 \cdot I_1$. In diesem Fall wird der Knoten 2 mit dem Differenzstrom $I_1 - I_3 = I_1 - 2/3\ I_1 = 1/3\ I_1$ in positiver Richtung aufgeladen.

Befindet sich jedoch der Knoten 2 auf $V_{DD}$ und damit der Oszillatorausgang auf $V_{SS}$, so ist P6 leitend gesteuert und damit $I_2' = I_2$. Damit wird $I_3 = 1/3\ (I_2 + I_4)$. Da $I_2 = I_4 = 2 \cdot I_1$ ist, wird $I_3 = 4/3\ I_1$. Damit wird für den Fall, daß P6 leitend ist, der Knoten 2 mit dem Differenzstrom $I_1 - I_3 = - 1/3\ I_1$ in negativer Richtung aufgeladen.

Zwischen den beiden möglichen Anfangsbedingungen kann sich also ein Gleichgewichtszustand einstellen, bei dem $I_3 = I_1$ ist. Dieser Zustand wird erreicht, wenn die Oszillatorausgangsspannung annähernd dem Wert der P-Kanal-Schwellspannung entspricht. In diesem Fall wird P6 nur schwach leitend und mit $I_2' = 1/2\ I_2$ wird der Gleichgewichtszustand (DC-Arbeitspunkt) erreicht, da $I_3 = 1/3 \cdot (I_2' + I_3) = I_1$ ist.

Die Schaltung nach der Erfindung bleibt daher unabhängig von der Versorgungsspannung in einem Gleichspannungsarbeitspunkt, bei dem die Spannung an $OSZ_{OUT}$ annähernd der P-Kanal-Schwellspannung entspricht. Diese Arbeitspunkteinstellung bietet als zusätzlichen Vorteil eine einfache Dimensionierung des üblicherweise auf den Oszillatorausgang folgenden Taktsignalverstärkers.

Die genannte Arbeitspunkteinstellung bleibt auch bei Ansteuerung mit einem Sinussignal erhalten. Da hierbei durch das Oszillatorausgangssignal der Transistor P6 wechselweise leitend gesteuert und gesperrt wird, schwankt der Strom, der in den Knoten 2 fließt, jeweils zwischen $1/3\ I_1$ und $- 1/3\ I_1$. Damit bleibt der Arbeitspunkt der Schaltung auch bei Ansteuerung mit einem Sinuseingangssignal bei annähernd der P-Kanal-Schwellspannung an $OSZ_{OUT}$.

Da $I_1$ nur etwa 1 nA beträgt und der in den Knoten 2 fließende Strom nur $1/3\ I_1$ bzw. $- 1/3\ I_1$ ist, ergibt sich bei der angegebenen Dimensionierung nach der Figur 2 am Knoten 2 eine sehr hohe Impedanz in der Größenordnung von 1 G$\Omega$, d. h. die Gesamtschaltung "simuliert" einen extrem hochohmigen Rückkoppelwiderstand. Dies ist jedoch die Voraussetzung für eine kapazitive Kopplung des Oszillatoreingangssignals mit einer kleinen — leicht integrierbaren — Koppelkapazität von maximal einigen pF. Ein weiterer Vorteil der erfindungsgemäßen Schaltung besteht darin, daß aufgrund des extrem hochohmigen Rückkoppelwiderstandes eine Reduzierung der Stromaufnahme der gesamten Schaltung erzielt wird.

Wird die Schaltung nach der Erfindung durch ein positives Signal angesteuert, so wird der Differenzstrom, der in den Knoten 2 der Schaltung fließt, negativ. Umgekehrt wird der Differenzstrom, der in den Knoten 2 der Schaltung fließt, positiv, wenn die Schaltung mit einem negativen Signal angesteuert wird.

Es hat sich herausgestellt, daß eine möglichst geringe Abweichung des Differenzstroms vom Mittelwert das Gesamtverhalten der Schaltung günstig beeinflußt. Beim Beispiel der Figur 2 fließt in den Eingang (Knoten 2) ein Differenzstrom von $\pm 1/3\ I_1$, d. h. ein Strom mit wechselndem Vorzeichen, dessen Mittelwert 0 ist.

Einer weiteren Verringerung des Differenzstroms bei Aussteuerung (z. B. $\pm 0.1\ I_1$) steht im Grunde nur das Symmetrieverhalten (Exemplarstreuungen) der verwendeten Transistoren entgegen.

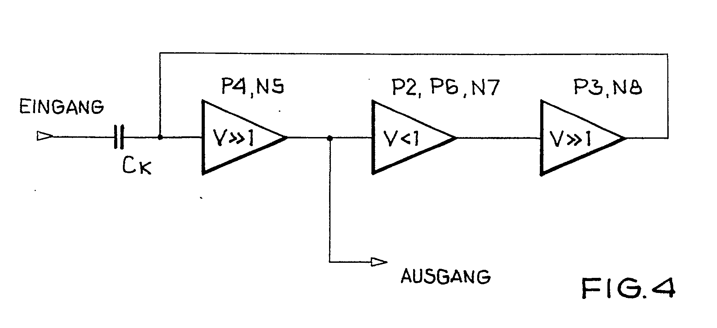

Die Figur 3 zeigt ein Ausführungsbeispiel der Erfindung, bei dem $I_3 = 2 \cdot I_1$ ist. Damit ist der Differenzstrom $I_{IN} = \pm I_1$. Die Schaltung der Figur 3 unterscheidet sich von der Schaltung der Figur 2 dadurch, daß der Transistor P9 und damit der Stromspiegel $I_4$ entfällt. Anhand dieser vereinfachten Schaltung, sowie anhand der daraus abgeleiteten Prinzipschaltung nach Figur 4 soll die Funktion der Schaltung nochmals verdeutlicht werden.

Bei der Schaltung nach der Figur 3 wird der Rückkoppelwiderstand durch die aktiven Elemente (Transistoren) P2, P6, N7 sowie P3 und N8 simuliert. Hierbei ist zu beachten, daß außer der eigentlichen invertierenden Verstärkerstufe (P4, P5) die Transistoren P2, P6, N7 sowie P3 und N8 jeweils ebenfalls eine invertierende Verstärkerstufe bilden, wobei die Stufe aus P2, P6 und N7 eine Spannungsverstärkung < 1 und die Stufe aus P3 und N8 eine Spannungsverstärkung >> 1 liefert. Diese Prinzipschaltung zeigt die Figur 4. Die Koppelkapazität $C_k$ bewirkt nicht nur eine kapazitive Ankopplung, sondern auch eine Frequenzkompensation, da die Schaltung ohne die Kapazität von selbst schwingen würde.

**Patentansprüche**

1. Verstärkerschaltung mit einem eine Rückkopplung aufweisenden Verstärker (P4, N5) und einer Stromquelle ($I_Q$) dadurch gekennzeichnet, daß
— der Eingang (E) des Verstärkers (P4, N5) mit einem ersten Schaltungszweig verbunden ist, dem ein erster Strom ($I_1$) durch die Stromquelle ($I_Q$) über eine erste Stromspiegelschaltung (P1, P3) aufgeprägt wird,
— mit einem zweiten Schaltungszweig, dem ein zweiter Strom ($I_2$) durch die Stromquelle ($I_Q$) über eine zweite Stromspiegelschaltung (P1, P2) aufgeprägt wird, wobei das Stromspiegelverhalten der zweiten Stromspiegelschaltung (P1, P2) über das Ausgangssignal des Verstärkers (P4, N5) gesteuert wird,
— mit einem als Rückkopplung dienenden dritten Schaltungszweig, der mit dem Eingang (E) des Verstärkers (P4, N5) verbunden ist und dem durch eine dritte Stromspiegelschaltung (N7, N8) ein dritter Strom ($I_3$) vom zweiten Schaltungszweig bzw. vom zweiten Schaltungszweig und einem vierten Schaltungszweig herübergespiegelt wird, wobei dem vierten Schaltungszweig ein vierter Strom ($I_4$) durch die Stromquelle ($I_Q$) über eine vierte Stromspiegelschaltung (P1, P9) aufgeprägt wird.

2. Verstärkerschaltung nach Anspruch 1, dadurch gekennzeichnet, daß die Schaltungselemente in CMOS-Technologie realisiert sind.

3. Verstärkerschaltung nach einem der vorangehenden Ansprüche, dadurch gekennzeichnet, daß der Eingang (E) des Verstärkers (P4, N5) über eine kapazitive Ankopplung ($C_k$) angesteuert wird.

4. Verstärkerschaltung nach einem der vorangehenden Ansprüche, dadurch gekennzeichnet, daß sie Teil einer integrierten Oszillatorschaltung ist.

**Claims**

1. An amplifier circuit with an amplifier (P4, N5) having a feedback coupling and with a current source $I_Q$ **characterised in that**
— the input (E) of the amplifier (P4, N5) is connected to a first circuit branch, on to which a first current ($I_1$) is impressed by the current source ($I_Q$) via a first current mirror circuit (P1, P3),
— to a second circuit branch, on to which a second current ($I_2$) is impressed by the current source ($I_Q$) via a second current mirror circuit (P1, P2), in which the current mirror characteristics of the second current mirror circuit (P1, P2) are controlled by means of the output signal of the amplifier (P4, N5),
— to a third circuit branch serving as a feedback coupling, which is connected to the input (E) of the amplifier (P4, N5) and to which a third current ($I_3$) is mirrored across by a third current mirror circuit (N7, N8) from the second circuit branch and/or from the second circuit branch and a fourth circuit branch, in which a fourth current ($I_4$) is impressed on to the fourth circuit branch by the current source ($I_Q$) via a fourth current mirror circuit (P1, P9).

2. An amplifier circuit according to claim 1, **characterised in that** the circuit elements are implemented in CMOS technology.

3. An amplifier circuit according to any one of the preceding claims, **characterised in that** the input (E) of the amplifier (P4, N5) is controlled by means of a capacitive coupling ($C_k$).

4. An amplifier circuit according to any one of the preceding claims, **characterised in that** it is part of an integrated oscillator circuit.

**Revendications**

1. Circuit amplificateur avec un amplificateur (P4, N5) présentant une réaction, et avec une source de courant ($I_Q$), caractérisé en ce que
— l'entrée (E) de l'amplificateur (P4, N5) est reliée à une première dérivation à laquelle est appliquée par la source de courant ($I_Q$) un premier courant ($I_1$) par l'intermédiaire d'un premier circuit à courant en rapport géométrique (P1, P3),

— avec une seconde dérivation à laquelle est appliqué par la source de courant ($I_Q$) un deuxième courant ($I_2$) par l'intermédiaire d'un second circuit à courant en rapport géométrique (P1, P2), le comportement de courant en rapport géométrique du second circuit de courant en rapport géométrique (P1, P2) étant commandé par l'intermédiaire du signal de sortie de l'amplificateur (P4, N5),

— avec une troisième dérivation servant de réaction qui est reliée à l'entrée (E) de l'amplificateur (P4, N5) et à laquelle est appliqué par un troisième circuit à courant en rapport géométrique (N7, N8) un troisième courant ($I_3$) de la seconde dérivation ou de la seconde dérivation et d'une quatrième dérivation, un quatrième courant ($I_4$) étant appliqué par la source de courant ($I_Q$) à la quatrième dérivation par l'intermédiaire d'un quatrième circuit à courant en rapport géométrique (P1, P9).

2. Circuit amplificateur selon la revendication 1, caractérisé en ce que les éléments de circuit sont réalisés en technologie CMOS.

3. Circuit amplificateur selon l'une quelconque des revendications précédentes, caractérisé en ce que l'entrée (E) de l'amplificateur (P4, N5) est commandée par l'intermédiaire d'un couplage capacitif ($C_K$).

4. Circuit amplificateur selon l'une quelconque des revendications précédentes, caractérisé en ce qu'il fait partie d'un circuit oscillateur intégré.

FIG.1

FIG.2

FIG.3

EINGANG

$C_K$

P4,N5

$V \gg 1$

P2, P6, N7

$V < 1$

P3, N8

$V \gg 1$

AUSGANG

FIG.4